(19) **Europäisches Patentamt**
**European Patent Office**
**Office européen des brevets**

(11) **EP 1 266 450 B1**

(12) **EUROPÄISCHE PATENTSCHRIFT**

(45) Veröffentlichungstag und Bekanntmachung des Hinweises auf die Patenterteilung:
**20.08.2008 Patentblatt 2008/34**

(21) Anmeldenummer: **01919127.9**

(22) Anmeldetag: **02.02.2001**

(51) Int Cl.:
*H03H 9/64* *(2006.01)*    *H03H 9/145* *(2006.01)*

(86) Internationale Anmeldenummer:
**PCT/DE2001/000407**

(87) Internationale Veröffentlichungsnummer:
**WO 2001/065689 (07.09.2001 Gazette 2001/36)**

(54) **TRANSVERSALMODEN-GEKOPPELTES RESONATORFILTER MIT VERRINGERTEM PLATZBEDARF**

RESONATOR FILTER THAT IS COUPLED TO TRANSVERSE MODES AND REQUIRES LESS SPACE

FILTRE DE RESONATEUR COUPLE EN MODE TRANSVERSAL A ENCOMBREMENT REDUIT

(84) Benannte Vertragsstaaten:
**DE FR GB**

(30) Priorität: **29.02.2000 DE 10009511**

(43) Veröffentlichungstag der Anmeldung:
**18.12.2002 Patentblatt 2002/51**

(73) Patentinhaber: **EPCOS AG**
**81669 München (DE)**

(72) Erfinder:
• **Dr. BECKERING, Claudia**
**85635 Höhenkirchen-Siegertsbrunn (DE)**
• **BERGMANN, Andreas**
**84533 Haiming (DE)**

• **JOHANNES, Thomas**
**deceased (DE)**

(74) Vertreter: **Epping - Hermann - Fischer Patentanwaltsgesellschaft mbH Ridlerstrasse 55 80339 München (DE)**

(56) Entgegenhaltungen:
**EP-A- 0 899 874          US-A- 5 666 092**

• **1973 ultrasonics symposium proceedings; Monterey,5-7 Nov. 1973; C.S. Hartmann: weighting interdigital surface wave transducers by selective withdrawal of electrodes; p423-426. XP002170038**

EP 1 266 450 B1

**Beschreibung**

Die Erfindung betrifft ein Transversalmodengekoppeltes Resonatorfilter (TMR-Filter) für kleine beziehungsweise verringerte Chipfläche.

Ein TMR-Filter besteht aus zumindest zwei Oberflächenwellenresonatoren, die in Transversalrichtung so nebeneinander angeordnet sind, daß eine akustische Kopplung auftritt. Gekoppelte Resonatoren bilden dabei gemeinsame Schwingungsmoden aus, die das Verhalten des TMR-Filters bestimmen. Die Anzahl der annähernd verlustfrei geführten Moden, die zu einem Passband beitragen, ist abhängig von der Anzahl der Resonatoren und deren Apertur Ap. TMR-Filter finden insbesondere im Bereich der Kanalselektion für verschiedene Mobilfunksysteme verbreitete Anwendung.

Ein TMR-Filter ist beispielsweise aus dem Artikel von C.S. Hartmann et all "Modeling of SAW transversiny coupled resonators filters using coupling-of US modes modeling technique" in 1992 Ultra Sonics Symposium, Seite 39 bis 43 bekannt. Jeder der zwei Resonatoren des TMR-Filters besteht aus einem Interdigitalwandler, der zwischen zwei Reflektoren angeordnet ist. Nebeneinander liegende und akustisch gekoppelte Resonatoren weisen üblicherweise eine gemeinsame mittlere Stromschiene auf. Charakteristische Größen, die die Eigenschaften des Resonators und damit des TMR-Filters bestimmen, sind neben der Apertur Ap die Gesamtzahl der Überlappungen $N_{ges}$ und die gewählte Mittenfrequenz $f_0$.

Insbesondere bei der Verwendung für Mobilfunksysteme wird bei Filtern Wert auf geringe Größe und daher auf geringen Bedarf an Chipoberfläche gelegt. Wegen der vergleichsweise großen Längenausdehnung gilt es insbesondere die Länge der TMR-Filter zu reduzieren, während die Breite der Filter durch die Anzahl der Spuren beziehungsweise Resonatoren bestimmt ist. Eine Reduzierung der Gesamtlänge eines TMR-Filters kann einerseits durch eine größere Mittenfrequenz $f_0$ oder durch eine niedrigere Gesamtzahl der Überlappungen $N_{ges}$ erreicht werden. Da die Mittenfrequenz $f_o$ üblicherweise durch das gegebene Mobilfunksystem nach oben begrenzt ist, verbleibt somit nur die Möglichkeit, $N_{ges}$ zu minimieren, um die Spurlänge eines TMR-Filters zu verringern. Dabei werden allerdings eine Reihe von Nachteilen erhalten. So steigt beispielsweise der Realteil der komplexen Impedanz durch eine zu geringe Anzahl an aktiven Überlappungen an. Gleicht man dies durch eine Erhöhung der Apertur der TMR-Spuren aus, so ist dies mit einer Verringerung der relativen Bandbreite des Filters verbunden. Für die meisten Mobilfunksysteme darf jedoch eine gewisse Mindestbandbreite nicht unterschritten werden. Reduziert man zur Verringerung der Gesamtlänge eines TMR-Filters die Anzahl der Reflektorfinger zugunsten der aktiven Überlappungen, so erhöht sich die minimale Einfügedämpfung, so daß die Übertragungsverluste unzulässig ansteigen.

Die Nachteile hoher Impedanz, geringer relativer Bandbreite und hoher Einfügedämpfung können durch die Verwendung von (anti-) parallelen Spuren umgangen werden. Dazu werden zwei TMR-Spuren, die jeweils für sich bereits TMR-Filter darstellen und deren Passbänder leicht frequenzversetzt sind, so parallel geschaltet, daß deren elektrische Signale am Ausgang gegenphasig sind. Als Nebeneffekt muß dabei jedoch eine beträchtliche Verminderung der Selektion im nahen Stoppbandbereich in Kauf genommen werden. Dies ist darauf zurückzuführen, daß weitere ungewünschte parasitäre Schwingungsmoden in den Resonatoren auftreten, die sich außerhalb des Paßbandes und bei Strahlungsmoden oberhalb des Paßbandes bemerkbar machen.

Eine Erhöhung der Selektion kann durch Kaskadierung, also durch Seriellverschalten mehrerer TMR-Spuren erhöht werden.

Dies erhöht jedoch auch den Platzbedarf des TMR-Filters auf der Chipoberfläche und widerspricht daher dem Wunsch nach Miniaturisierung.

Durch eine größere Metallisierungshöhe kann die Impedanz eines TMR-Filters erniedrigt werden. Dabei wird jedoch gleichzeitig die Abhängigkeit der Mittenfrequenz $f_0$ von der Metallisierungshöhe verstärkt, so daß aufgrund von Höhenschwankungen frequenzgenaue Bauteile nicht mehr kostengünstig zu fertigen sind.

Aufgabe der vorliegenden Erfindung ist es daher, Maßnahmen zur Ausgestaltung eines TMR-Filter anzugeben, die eine Reduzierung der Chipoberfläche ermöglichen, ohne daß die genannten Nachteile in Kauf genommen werden müssen.

Diese Aufgabe wird erfindungsgemäß durch ein TMR-Filter nach Anspruch 1 gelöst. Vorteilhafte Ausgestaltungen der Erfindung gehen aus den Unteransprüchen hervor.

Die Erfindung nutzt den vorteilhaften Effekt, der durch Parallelschaltung zweier TMR-Einzelspuren erzielt wird, deren Resonanzfrequenzen $f_o$ leicht gegeneinander versetzt sind. Unerwünschte parasitäre Moden, die zu einer Verringerung der Selektion führen würden, werden bei der Erfindung durch eine longitudinale Wichtung der Interdigitalwandler vermieden. Dazu werden Anregungszellen und bezüglich der Anregung inaktive Fingergruppen gemäß einer Verteilungsfunktion verteilt, deren Maximum für die Anregungszellen in der Mitte und deren Minima am Rand des Interdigitalwandlers liegen. Dies führt gegenüber einem ungewichteten Wandler zu einer verbesserten Selektion der TMR-Einzelspur, wobei allerdings gleichzeitig die Bandbreite eines Einzelresonators, also einer TMR-Halbspur ansteigt. Da die Bandbreite des TMR-Filters jedoch in erster Linie durch die Kopplung der Resonanzfrequenzen zweier Halbspuren bestimmt wird, hat dies nur einen geringfügigen Einfluß auf die Bandbreite des gesamten Filters. Durch die Wichtung, insbesondere durch die Einfügung nicht anregender Fingergruppen steigt bei ansonsten gleichbleibender Länge der akustischen Spur $l_{ak}$ die Impedanz des Interdigitalwandlers. Bei der Erfindung kann dem entgegengewirkt werden, indem die Länge $l_{ak}$ der akustischen Spur zu Lasten der Reflektoren vergrößert wird. Anders als bei einem ungewichteten Wandler führt dies nicht zu einem deutlichen Anstieg der Einfügedämpfung, da aufgrund der Wichtung an den Enden der Interdigitalwandler nur eine verminderte Anregung stattfindet, so daß weniger Energie in den Reflektor läuft, und der Verlust durch die verminderte Anzahl an Reflektorfingern daher deutlich kleiner als im ungewichteten Fall ist. Die geringfügige Erhöhung des Realteils der Impedanz infolge der Wichtung des Interdigitalwandlers ist ebenfalls unkritisch, da durch die Parallelschaltung von TMR-Einzelspuren das TMR-Filter von vornherein eine niedrige Impedanz aufweist.

Eine weitere Verfeinerung der longitudinalen Wichtung wird durch entsprechende Auswahl der Anregungszellen erreicht. Insbesondere durch geeignete Auswahl der Länge der Anregungszellen und Wichtung der Anregungszellen wird die Anregung parasitärer Moden im Resonator weiter unterdrückt. Zulässig sind dabei alle Wichtungsmethoden, bei denen sich die Apertur in longitudinaler Richtung und damit auch das transversale Wellenprofil über die Länge des Resonators hin nicht ändert. Diese Bedingung wird beispielsweise durch die Weglaßwichtung in jedem Fall erfüllt. Die longitudinale Verteilung der Anregungszellen über den Interdigitalwandler stellt im Prinzip eine solche Weglaßwichtung des Wandlers dar, bei der die Einzelüberlappung, also das einzelne Anregungszentrum durch Anregungszellen ersetzt ist. Die Anregungszellen selbst können dabei eine beliebige Wichtung aufweisen, insbesondere ebenfalls eine Weglaßwichtung oder Überlappwichtung.

Vorzugsweise besitzen alle Anregungszellen die gleiche Länge und weisen die gleiche Anregungsstärke auf. Besonders vorteilhaft ist dabei, wenn alle Anregungszellen gleich sind.

Vorzugsweise sind auch alle Einzelresonatoren (TMR-Halbspuren) und damit auch die TMR-Einzelspuren mit Ausnahme der Mittenfrequenz, die sich in den Resonatoren unterscheiden kann, gleich aufgebaut.

Von Vorteil ist es, wenn die Verteilungsfunktion nach einer Fouriertransformation gegenüber der sin (x) /x-Funktion minimierte Nebenmaxima erzeugt. Ein Beispiel für eine solche Funktion stellt die Gauß-Funktion $Be^{-ßx2}$ mit reellen Parametern B und ß dar, die keine Nebenmaxima aufweist. Annähernd gilt dies auch für Dreiecksfunktionen.

In einer vorteilhaften Ausgestaltung der Erfindung weisen die Anregungszellen ein durch Überlappwichtung eingestelltes transversales Anregungsprofil auf, welches ebenfalls einer gegenüber der Fouriertransformation invarianten Funktionen angenähert ist. Damit entsteht ein transversales Wellenprofil, welches nicht mehr rechteckförmig ist und welches Strahlungsmoden im oberen Stoppband wirkungsvoll unterdrückt. Damit wird auch ein erheblicher Gewinn an Selektion im oberen Stoppband, also bei einer Frequenz oberhalb der Mittenfrequenz erreicht.

Eine weitere mögliche Wichtung für die Interdigitalwandler besteht in einer elektrischen Serienschaltung von mehreren Überlappungen eines wandlers in transversaler Richtung. Dies kann dadurch erfolgen, daß zumindest in einem Längenabschnitt eines Interdigitalwandlers die Elektrodenfinger aufgeteilt werden und zumindest eine weitere floatende Stromschiene mit Elektrodenfingern dazwischen angeordnet wird, die Überlappungen mit den beiden Teilen des aufgetrennten Wandlers zeigt. Eine solche Auftrennung kann über die Länge des Wandlers gesehen in unterschiedlichen Bereichen auf unterschiedliche Weise erfolgen, wobei alle diese Bereiche durch gemeinsame äußere Stromschienen parallel geschaltet sind. Die durch (n-1) floatende Stromschienen bewirkte Aufteilung der Gesamtapertur Ap in n Teilaperturen mit $a_1 + a_2 + ...an = Ap$ führt zu einer Änderung der statischen Kapazität C gemäß

$$C' = \frac{C}{Ap}\left(\frac{1}{a1} + \frac{1}{a2} + ... + \frac{1}{an}\right)^{-1}$$

mit C'<C. Gemäß der Änderung in C wird damit auch die Anregungsstärke variiert. Je nach Aufteilung der ursprünglichen Apertur Ap können somit verschiedene Anregungsstärken realisiert werden.

Insgesamt lassen sich mit der Erfindung TMR-Filter auf geringerer Chipfläche mit dennoch ausreichend hoher Selektion erzeugen. Damit werden auch bei Frequenzen unterhalb von 500 Megahertz miniaturisierte Filter möglich, deren Eigenschaften den Anforderungen von GSM-Systemen entsprechen. Insbesondere ist dies eine relative Bandbreite größer 0,1 %, eine Impedanz kleiner 1,5 kΩ und Einfügedämpfung kleiner 4 dB.

Im folgenden wird die Erfindung anhand von Ausführungsbeispielen und der dazugehörigen acht Figuren näher erläutert.

Figur 1     zeigt ein bekanntes aus zwei Resonatoren bestehendes TMR-Resonatorfilter

Figur 2     zeigt eine bekannte Antiparallelverschaltung zweier TMR-Einzelspuren

Figur 3     zeigt eine bekannte Kaskadenverschaltung zweier TMR-Einzelspuren mit Koppelelement

Figur 4     zeigt die Durchlaßkurven antiparallel und seriell verschalteter TMR-Einzelspuren

Figur 5     zeigt verschiedene Formen von Anregungszellen

Figur 6     zeigt die Verteilung von Anregungszellen in einem Resonator

Figur 7     zeigt die Durchlaßkurven zweier antiparallel geschalteter TMR-Einzelspuren mit und ohne Wichtung

Figur 8 zeigt einen Resonator mit parallelen Teilwandlern, in denen teilweise Überlappungen seriell verschaltet sind.

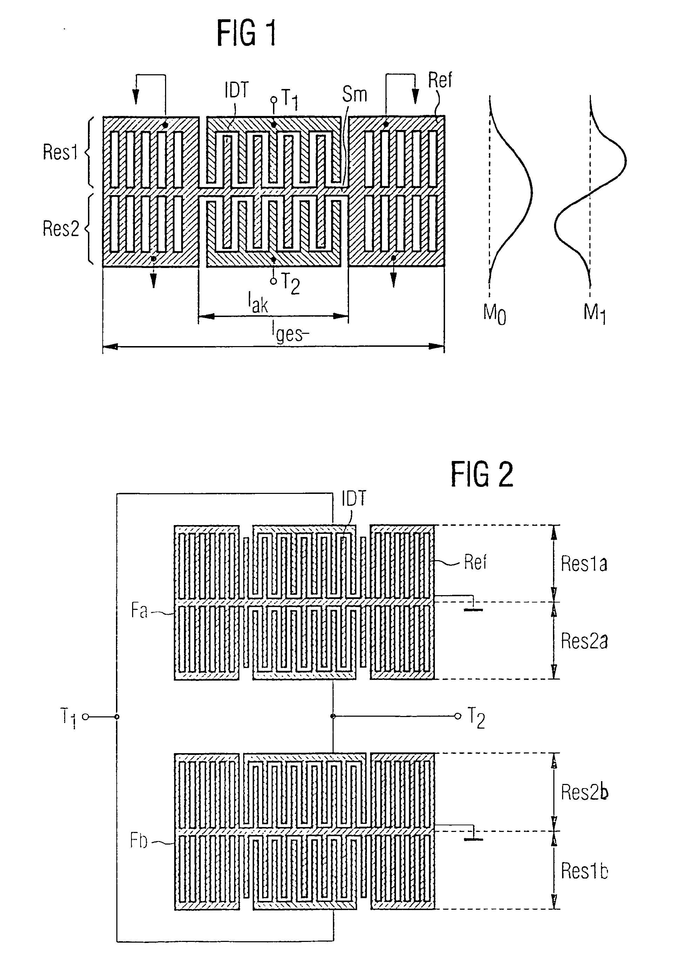

Figur 1 zeigt ein beispielsweise aus dem genannten Artikel von Hartmann et al. bekanntes TMR-Filter. Dieses umfaßt zwei Resonatoren Res1 und Res2, die akustisch gekoppelt sind und eine gemeinsame mittlere Stromschiene Sm aufweisen. Jeder Resonator Res besteht aus einem Interdigitalwandler IDT, der zwischen zwei Reflektoren Ref angeordnet ist. Durch die akustische Kopplung der beiden Resonatoren Res bilden sich gemeinsame Schwingungsmoden aus, von denen die Mode M0 und M1 rechts neben dem TMR-Filter angedeutet sind. Die akustische Spurlänge $l_{ak}$ und die mit der Gesamtlänge des TMR-Filters übereinstimmende Länge $l_{ges}$ der Resonatoren Res sind weitere Kenngrößen des TMR-Filters. Mit T1 und T2 sind die signalführenden Ein- und Ausgänge des Filters bezeichnet. Die Resonatoren Res sind mit der mittleren Stromschiene Sm verbunden und liegen auf Masse.

Werden zwei solcher TMR-Filter antiparallel verschaltet, so erhält man ein TMR-Filter mit gegenüber der Einzelspur F1 oder F2 erniedrigter Impedanz, erhöhter Bandbreite und verbesserter Einfügedämpfung. Bei der elektrischen Verschaltung handelt es sich um eine sogenannte Antiparallelverschaltung, da die beiden mit dem Anschluß T2 verbundenen Resonatoren Res2a und Res2b durch gegeneinander Verschieben der Fingeranschlußfolge bezüglich des elektrischen Signals gegenphasig sind. Zu einer Auslöschung des Signals kommt es aber nicht, da die Resonanzfrequenzen der beiden TMR-Einzelspuren Fa und Fb leicht gegeneinander versetzt sind.

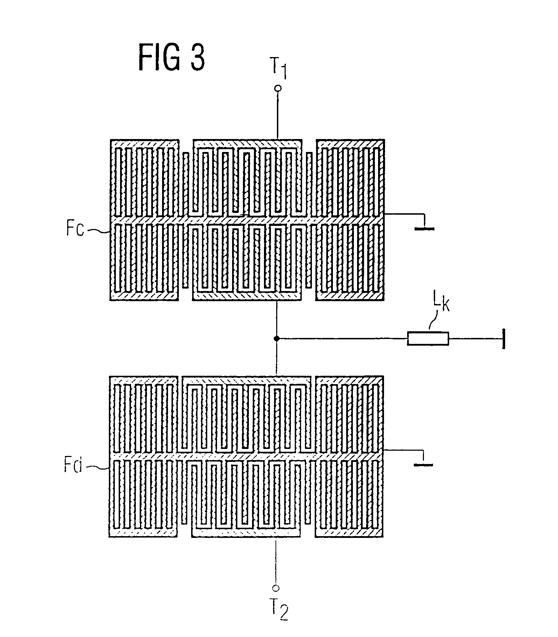

Figur 3 zeigt die bekannte Möglichkeit, zwei TMR-Einzelspuren Fc und Fd elektrisch in Serie zu schalten, wobei die Koppelstelle über eine Koppelinduktivität Lk mit Masse verbunden ist. Die beiden TMR-Einzelspuren sind dabei ebenso wie in der genannten Parallelschaltung akustisch nicht gekoppelt. Die auch Kaskadenschaltung genannte Serienverschaltung führt zu einer verbesserten Selektion.

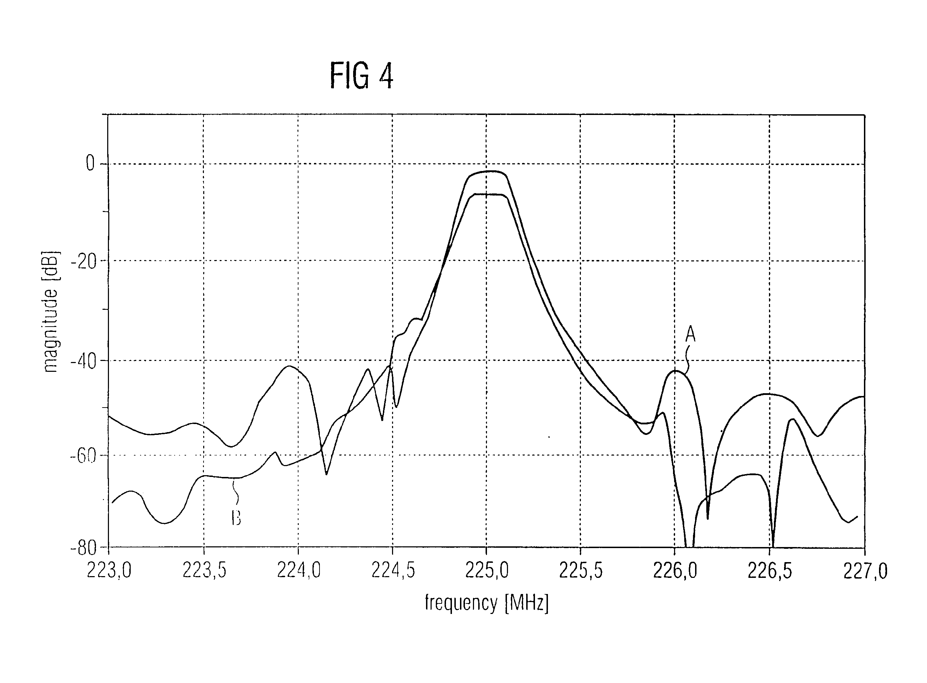

Figur 4 verdeutlicht die Vor- und Nachteile der beiden in den Figuren 2 und 3 dargestellten Verschaltungen mehrerer TMR-Einzelspuren F. Die Meßkurve B entspricht dem Durchlaßverhalten der in der Figur 3 dargestellten Kaskadierung zweier TMR-Einzelspuren. Die Meßkurve A dagegen entspricht dem Durchlaßverhalten zweier antiparallelverschalteter TMR-Einzelspuren, wie es in Figur 2 dargestellt wurden. Klar zu erkennen ist die verbesserte Einfügedämpfung bei der Antiparallelverschaltung, während die Seriellverschaltung (Kaskadierung) zu einer schlechteren Einfügedämpfung aber einer verbesserten Selektion führt, also zu einer besseren Dämpfung der Signale außerhalb des Durchlaßbereichs.

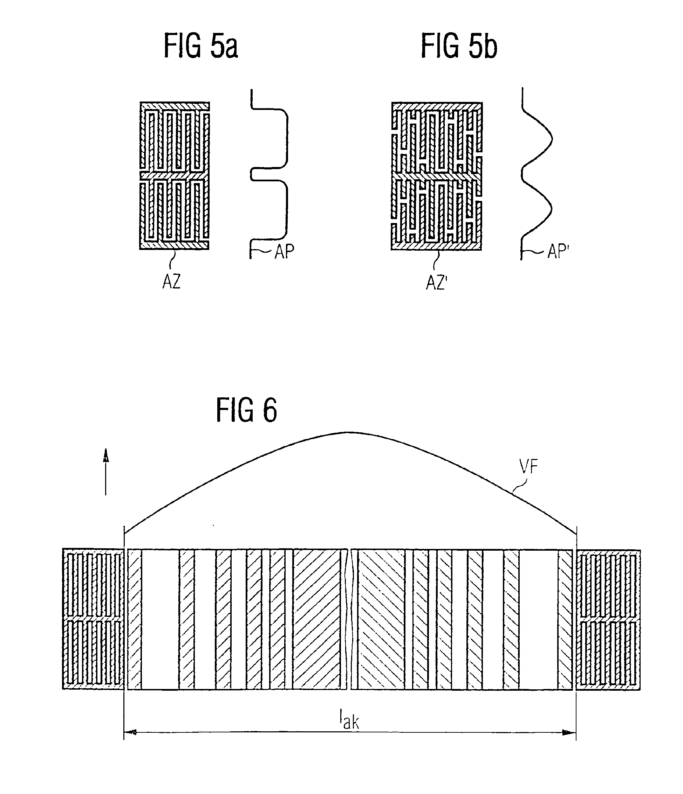

In Figur 5a und Figur 5b sind zwei beispielhafte Möglichkeiten dargestellt, wie die Anregungszellen für den Resonator eines erfindungsgemäßen TMR-Filters aufgebaut sein können. Eine solche Anregungszelle AZ, deren Länge ein Mehrfaches der Wellenlänge der Oberflächenwelle bei der Mittenfrequenz $f_0$ betragen kann, kann eine Normalfingeranordnung darstellen, mit einem Fingermittenabstand von $\lambda/2$. Vorteilhaft für die Erfindung sind jedoch Anregungszellen AZ, die eine Richtung aufweisen. Figur 5a stellt beispielsweise eine Anregungszelle mit Weglaßwichtung dar, die vorzugsweise durch eine Veränderung der Fingeranschlußfolge vorgenommen ist. Auch Figur 5b zeigt eine gewichtete Anregungszelle AZ', bei der durch Überlappwichtung das transversale Anregungsprofil AP' (jeweils rechts neben der Anregungszelle AZ dargestellt) von der Rechtecksfunktion, wie sie für ein transversales Anregungsprofil AP der Anregungszelle AZ mit Weglaßwichtung erhalten wird, abweicht.

Erfindungsgemäß werden nun mehrere solche Anregungszellen AZ gemäß einer Verteilungsfunktion VF über die Länge $l_{ak}$ des Interdigitalwandlers verteilt. Die Zwischenräume zwischen einzelnen oder auch Gruppen von Anregungszellen AZ sind mit nicht-anregenden Fingergruppen, also mit Elektrodenfingern ohne Überlappung aufgefüllt. Die Verteilungsfunktion VF ist so gewählt, daß sie in der Mitte des Interdigitalwandlers ein Maximum, an den Rändern dagegen jeweils ein Minimum aufweist. Figur 6 veranschaulicht eine solche mögliche Verteilung in einem Interdigitalwandler. Die dunklen beziehungsweise schraffiert dargestellten Bereiche des Interdigitalwandlers stehen beispielsweise für Anregungszellen AZ, während die helleren Bereiche inaktive Fingergruppen umfassen. Die Dichte anregender Anregungszellen AZ ist in der Mitte des Interdigitalwandlers am größten. In der Figur 6 ist die Verteilung der Anregungszellen AZ für eine TMR-Einzelspur dargestellt, die vorzugsweise in beiden TMR-Halbspuren, also in den beiden die TMR-Einzelspur bildenden Resonatoren identisch ist. Vorzugsweise sind innerhalb einer TMR-Einzelspur auch Anregungszellen einer einheitlichen Fingeranordnung beziehungsweise einer einheitlichen Wichtung verwendet.

Für ein erfindungsgemäßes TMR-Filter werden nun zwei solcher TMR-Einzelspuren, bei denen Anregungszellen beispielsweise gemäß Figur 5a über einen Resonator in einer Verteilungsfunktion beispielsweise gemäß Figur 6 verteilt sind in antiparalleler Verschaltung zu einem erfindungsgemäßen TMR-Filter verschaltet.

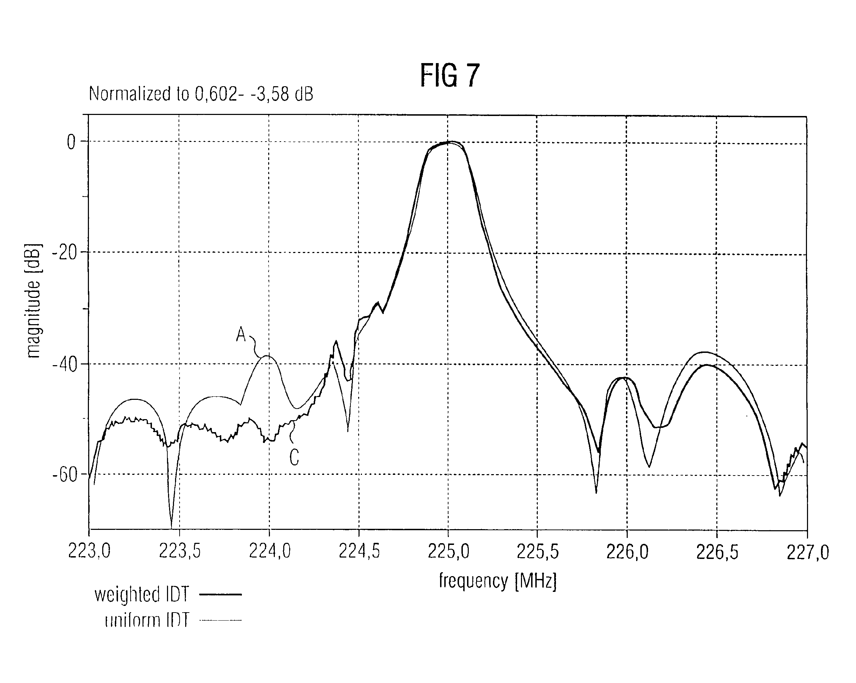

Figur 7 zeigt die vorteilhafte Verbesserung im Übertragungsverhalten eines erfindungsgemäßen TMR-Filters im Vergleich zu einem zum Beispiel in Figur 2 dargestellten bekannten TMR-Filter mit Antiparallelverschaltung zweier ungewichteter TMR-Einzelspuren. Während die Kurve A das Durchlaßverhalten des bekannten Filters zeigt, gibt die Kurve C das Durchlaßverhalten eines erfindungsgemäßen TMR-Filters an, bei dem erfindungsgemäß Anregungszellen AZ gemäß einer geeigneten Verteilungsfunktion VF über den Interdigitalwandler IDT verteilt sind. Klar zu erkennen ist, wie gemäß der erfindungsgemäßen Anordnung der Anregungszellen die Selektion im Stoppband verbessert wird, und wie insbesondere parasitäre Moden unterdrückt werden können.

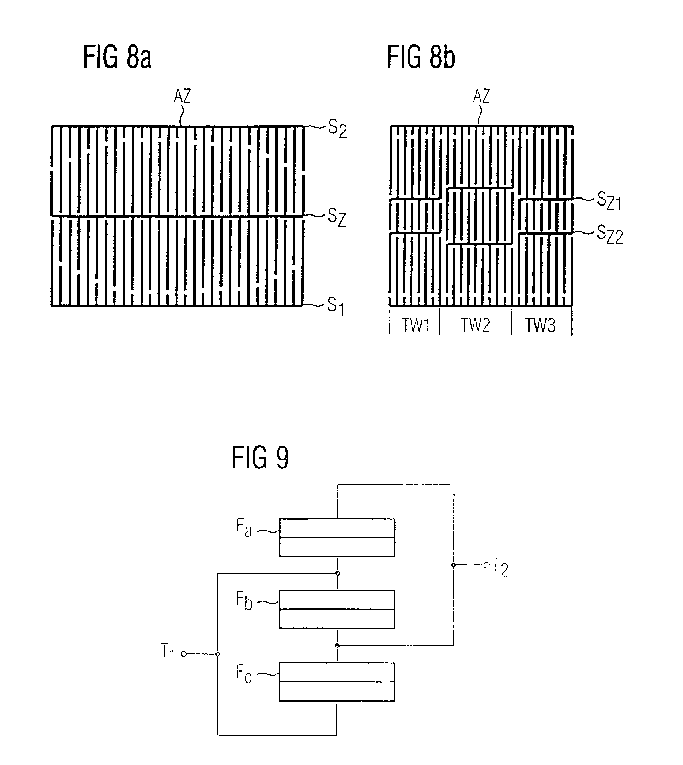

Eine weitere Möglichkeit der Wichtung, wie sie auch erfindungsgemäß in einer Anregungszelle AZ verwendet werden kann, ist beispielsweise in Figur 8 dargestellt. Eine Wichtung der Anregung kann dabei durch Auftrennung der Elektrodenfinger, Einführung einer zusätzlichen floatenden Stromschiene SZ mit Elektrodenfingern, die mit den Elektrodenfingern der ursprünglichen Stromschienen S1 und S2 zusätzliche Überlappungen ausbildet, dargestellt werden. Es handelt sich dabei um in transversaler Richtung seriell verschaltete Überlappungen. Durch die zusätzliche Stromschiene SZ entstehen Teilspuren mit gegebenenfalls unterschiedlichen Spurbreiten, die gegenüber der ungeteilten Spurbreite reduziert sind. In Figur 8a ist ein solcher Teilwandler, der als Anregungszelle AZ verwendet werden kann, dargestellt. Der Teilwandler wird durch die zusätzliche Stromschiene SZ symmetrisch geteilt, was aber nicht erforderlich ist. Die zusätzlichen Überlappungen sind gewichtet, so daß insgesamt auch der Teilwandler beziehungsweise die Anregungszelle AZ gewichtet ist. Mit der Seriellverschaltung von Überlappungen wird auch ohne zusätzliche Wichtung die Anregungsfunktion eines solchen Teilwandlers beziehungsweise einer solchen Anregungszelle AZ gewichtet.

Figur 8b zeigt eine weitere Möglichkeit dieses Prinzip der Seriellverschaltung von Überlappungen in Anregungszellen AZ einzusetzen. Hier besteht eine Anregungszelle AZ aus in longitudinaler Richtung gesehen drei Teilwandlern TW1, TW2 und TW3, die jeweils durch zwei zusätzliche Stromschienen SZ1, SZ2 dreifach serienverschaltete Überlappungen aufweisen. Die Spurbreite der durch die zusätzlichen Stromschienen SZ entstandenen Teilspuren der Teilwandler TW können dabei unterschiedlich sein, und zwar sowohl innerhalb eines Teilwandlers als auch von einem Teilwandler zum anderen, wie es in Figur 8b dargestellt ist. Dabei kann auch die Zahl der mit zusätzlichen Stromschienen SZ verbundenen Elektrodenfinger variieren. Neben den Ausführungen mit ein und zwei zusätzlichen Stromschienen SZ sind auch weitere Ausführungen möglich, bei denen mehr als die dargestellten zwei zusätzlichen Stromschienen eingefügt werden. Möglich ist es auch, eine Anregungszelle aus Teilwandlern zusammenzusetzen, die von Teilwandler zu Teilwandler eine unterschiedliche Anzahl von seriell verschalteten Teilspuren aufweisen. Auch die Anzahl der Teilwandler innerhalb einer Anregungszelle kann entsprechend der gewünschten Wichtung der Anregungszelle unterschiedlich gewählt sein.

Figur 9 zeigt eine Möglichkeit, wie drei oder mehr TMR-Teilspuren F parallel zu einem TMR-Filter verschaltet werden können. Die nur symbolisch dargestellten TMR-Teilspuren Fa bis Fc weisen dabei jeweils gegeneinander versetzte Resonanzfrequenzen auf. Vorzugsweise ist dabei jede TMR-Einzelspur gegen diejenige TMR-Einzelspur antiparallel verschaltet, deren Resonanzfrequenzen direkt benachbart sind. Vorzugsweise weisen alle TMR-Einzelspuren voneinander verschiedene Resonanzfrequenzen auf. Es können auch mehr als drei TMR-Einzelspuren miteinander verschaltet werden, wobei wieder darauf zu achten ist, daß die TMR-Einzelspuren mit benachbarten Resonanzfrequenzen bezüglich der elektrischen Phase zueinander antiparallel sind.

Die Erfindung kann mit den Ausführungsbeispielen nur exemplarisch dargestellt werden, ist aber nicht auf diese beschränkt. Im Rahmen der Erfindung liegt es daher, beliebige Variationen bezüglich der Anregungszellen, der gewählten Verteilungsfunktion und sonstiger Parameter vorzunehmen, sofern diese dem erfindungsgemäßen Gedanken folgen.

**Patentansprüche**

1. Transversal Moden gekoppeltes Resonator - Filter, TMR-Filter,

   - mit zumindest zwei elektrisch parallel geschalteten TMR-Einzelspuren (Fa, Fb),
   - bei dem jede Einzelspur zumindest zwei akustisch gekoppelte Halbspuren mit einem Resonator (Res), aufweisend einen Interdigitalwandler (IDT) mit Anregungszellen (AZ) und bezüglich der Anregung inaktiven Fingergruppen,
   - bei dem in einer TMR-Einzelspur (F) die Anregungszellen in longitudinaler Richtung gemäß einer Verteilungsfunktion (VF) verteilt sind, deren Maximum in der Mitte und deren Minima am Rand des Interdigitalwandlers (IDT) liegen,
   - bei dem die Anregungszellen (AZ) eine Wichtung aufweisen.

2. TMR-Filter nach Anspruch 1, bei dem alle Anregungszellen (AZ) die gleiche Länge und die gleiche Anregungsstärke aufweisen.

3. TMR-Filter nach Anspruch 2, bei dem alle Anregungszellen (AZ) gleich sind.

4. TMR-Filter nach einem der Ansprüche 1-3, bei dem die Anregungszellen (AZ) ein transversales Anregungsprofil aufweisen.

5. TMR-Filter nach einem der Ansprüche 1-4, mit gegeneinander frequenzversetzten TMR-Einzelspuren (F), wobei die TMR-Einzelspuren (F) mit direkt benachbarten Resonanzfrequenzen elektrisch zueinander antiparallel sind.

6. TMR-Filter nach einem der Ansprüche 1-5,

bei dem alle TMR-Einzelspuren (F) die gleiche Verteilungsfunktion (VF) der Anregungszellen (AZ) aufweisen und bei dem alle Anregungszellen gleich sind.

7. TMR-Filter nach einem der Ansprüche 1-6, bei dem die Verteilungsfunktion (VF) für die Anregungszellen (AZ) einer Gaußfunktion oder einer Dreiecksfunktion angenähert ist.

8. TMR-Filter nach einem der Ansprüche 1-7, bei dem das transversale Anregungsprofil einer Anregungsfunktion angenähert ist, die nach einer Fouriertransformation gegenüber der sin(x)/x Funktion eine verringerte Anzahl von Nebenmaxima aufweist.

9. TMR-Filter nach einem der Ansprüche 1-8, bei dem das transversale Anregungsprofil der Anregungszellen (AZ) einer Gaußfunktion oder einer Dreiecksfunktion angenähert ist.

10. TMR-Filter nach einem der Ansprüche 1-8, bei dem jede der TMR-Einzelspuren (F) aus zumindest zwei akustisch gekoppelten Halbspuren (Res) mit je einem Interdigitalwandler (IDT) besteht, wobei einander zugewandte Stromschienen benachbarter Interdigitalwandler elektrisch getrennt, elektrisch verbunden oder zu einer gemeinsamen Stromschiene (Sm) verbunden sind.

11. TMR-Filter nach einem der Ansprüche 1-10, bei dem die Interdigitalwandler (IDT) zumindest teilweise eine Serienverschaltung von Teilwandlern (TW) mit reduzierter Apertur aufweisen.

12. TMR-Filter nach Anspruch 11, bei dem Überlappungsbereiche eines Interdigitalwandlers (IDT) in Serie geschaltet sind.

**Claims**

1. Transverse-mode-coupled resonator filter, TMR filter,

    - having at least two TMR single tracks (Fa, Fb) which are electrically connected in parallel,
    - in which each single track has at least two acoustically coupled half-tracks with a resonator (Res), having an interdigital transducer (IDT) with stimulation cells (AZ) and finger groups which are inactive in respect of the stimulation,
    - in which the stimulation cells in a TMR single track (F) are distributed in the longitudinal direction on the basis of a distribution function (VF) whose maximum is in the centre and whose minima are at the edge of the interdigital transducer (IDT),
    - in which the stimulation cells (AZ) have a weighting.

2. TMR filter according to Claim 1, in which all the stimulation cells (AZ) have the same length and the same stimulation level.

3. TMR filter according to Claim 2, in which all the stimulation cells (AZ) are alike.

4. TMR filter according to one of Claims 1-3, in which the stimulation cells (AZ) have a transverse stimulation profile.

5. TMR filter according to one of Claims 1-4, with TMR single tracks (F) whose frequencies are shifted relative to one another, the TMR single tracks (F) with directly adjacent resonant frequencies being electrically parallel to one another in opposite directions.

6. TMR filter according to one of Claims 1-5, in which all the TMR single tracks (F) have the same distribution function (VF) for the stimulation cells (AZ) and in which all the stimulation cells are alike.

7. TMR filter according to one of Claims 1-6, in which the distribution function (VF) for the stimulation cells (AZ) approximates a Gaussian function or a triangular function.

8. TMR filter according to one of Claims 1-7, in which the transverse stimulation profile approximates a stimulation function whose Fourier transform has a reduced number of secondary maxima in comparison with the sin(x)/x function.

9. TMR filter according to one of Claims 1-8, in which the transverse stimulation profile of the stimulation cells (AZ) approximates a Gaussian function or a triangular function.

10. TMR filter according to one of Claims 1-8, in which each of the TMR single tracks (F) comprises at least two acoustically coupled half-tracks (Res) with a respective interdigital transducer (IDT), where facing busbars of adjacent interdigital converters are electrically isolated, electrically connected or connected to form a common busbar (Sm).

11. TMR filter according to one of Claims 1-10, in which at least some of the interdigital transducers (IDT) have reduced-aperture subtransducers (TW) interconnected in series.

12. TMR filter according to Claim 11, in which areas of overlap in an interdigital transducer (IDT) are connected in series.

**Revendications**

1.  Filtre de résonateur couplé en mode transversal, filtre TMR,

    - comprenant au moins deux pistes ( Fa, Fb ) individuelles TMR montées électriquement en parallèle,
    - dans lequel chaque piste individuelle a au moins deux demi-pistes couplées acoustiquement comprenant un résonateur ( Res ) ayant un transducteur ( IDT ) interdigité à cellules ( AZ ) d'excitation et des groupes de doigts inactifs pour ce qui concerne l'excitation,
    - dans lequel, dans une piste ( F ) individuelle TMR, les cellules d'excitation sont réparties dans la direction longitudinale suivant une fonction ( VF ) de répartition, dont le maximum se trouve au milieu et dont les minimums se trouvent au bord du convertisseur ( IDT ) interdigité,
    - dans lequel les cellules ( AZ ) d'excitation ont une pondération.

2.  Filtre TMR suivant la revendication 1, dans lequel toutes les cellules ( AZ ) d'excitation ont la même longueur et la même force d'excitation.

3.  Filtre TMR suivant la revendication 2, dans lequel toutes les cellules ( AZ ) d'excitation sont identiques.

4.  Filtre TMR suivant l'une des revendications 1 à 3, dans lequel les cellules ( AZ ) d'excitation ont un profil d'excitation, qui est transversal.

5.  Filtre TMR suivant l'une des revendications 1 à 4, comprenant des pistes ( F ) individuelles TMR décalées mutuellement en fréquence, les pistes ( F ) individuelles TMR ayant des fréquences de résonance directement voisines étant antiparalles électriquement les unes par rapport aux autres.

6.  Filtre TMR suivant l'une des revendications 1 à 5, dans lequel toutes les pistes ( F ) individuelles TMR ont la même fonction ( VF ) de répartition des cellules ( AZ ) d'excitation et dans lequel toutes les cellules d'excitation sont identiques.

7.  Filtre TMR suivant l'une des revendications 1 à 6, dans lequel la fonction ( VF ) de répartition des cellules ( AZ ) d'excitation est à peu près une fonction gaussienne ou une fonction du triangle schwarzienne.

8.  Filtre TMR suivant l'une des revendications 1 à 7, dans lequel le profil d'excitation transversal a à peu près une fonction d'excitation qui a, suivant une transformation de Fourier, un nombre diminué de maximum secondaires par rapport à la fonction sinus ( x )/x.

9.  Filtre TMR suivant l'une des revendications 1 à 8, dans lequel le profil d'excitation transversal des cellules ( AZ ) d'excitation a à peu près une fonction gaussienne ou une fonction de triangle schwarzienne.

10. Filtre TMR suivant l'une des revendications 1 à 8, dans lequel chacune des pistes ( F ) individuelles TMR est constituée d'au moins deux demi-pistes ( Res ) couplées acoustiquement ayant, respectivement, un convertisseur ( IDT ) interdigité, des barres de courant, tournées l'une vers l'autre, de convertisseurs interdigités voisins étant séparées électriquement, reliées électriquement ou reliées en une barre ( Sm ) de courant commune.

11. Filtre TMR suivant l'une des revendications 1 à 10, dans lequel les convertisseurs ( IDT ) interdigités ont au moins en partie un montage série de sous-convertisseurs ( TW ) d'ouverture réduite.

12. Filtre TMR suivant la revendication 11, dans lequel des zones de chevauchement d'un convertisseur ( IDT ) interdigité sont montées en série.

## FIG 1

## FIG 2

## FIG 3

## FIG 4

## FIG 5a

AZ

~AP

## FIG 5b

AZ'

~AP'

## FIG 6

VF

$l_{ak}$

FIG 7

Normalized to 0,602- -3,58 dB

weighted IDT ———
uniform IDT ———

## FIG 8a

AZ

$S_2$

$S_Z$

$S_1$

## FIG 8b

AZ

$S_{Z1}$

$S_{Z2}$

| TW1 | TW2 | TW3 |

## FIG 9

$F_a$

$F_b$

$F_c$

$T_1$

$T_2$

**IN DER BESCHREIBUNG AUFGEFÜHRTE DOKUMENTE**

**In der Beschreibung aufgeführte Nicht-Patentliteratur**

- **C.S. HARTMANN.** Modeling of SAW transversiny coupled resonators filters using coupling-of US modes modeling technique. *Ultra Sonics Symposium,* 1992, 39-43